# EUROPEAN PATENT SPECIFICATION

(11) **EP 2 568 598 B1**
(45) Date of publication and mention of the grant of the patent: **26.02.2014**
(21) Application number: 11290396.8
(22) Date of filing: 06.09.2011
(51) Int. Cl.: H03F 1/02

(54) **Power amplifier for mobile telecommunications**
Leistungsverstärker für mobile Telekommunikation
Amplificateur de puissance pour télécommunications mobiles

(43) Date of publication of application: 13.03.2013
(60) Divisional application: 12008281.3
(73) Proprietor: Alcatel Lucent, 75007 Paris (FR)
(72) Inventor: Grebennikov, Andrei, Castleknock Dublin 15 (IE); Bulja, Senad, Dublin 15 (IE)
(74) Representative: Sarup, David Alexander

(56) References cited:
- EP-A1- 1 521 360
- EP-A2- 0 630 104
- US-A1- 2006 139 091
- US-A1- 2010 052 779
- JONGSIK LIM ET AL: "A balanced power amplifier utilizing the reflected input power", RADIO-FREQUENCY INTEGRATION TECHNOLOGY, 2009. RFIT 2009. IEEE INTERNATIONAL SYMPOSIUM ON, IEEE, PISCATAWAY, NJ, USA, 9 January 2009 (2009-01-09), pages 88-91, XP031640437, ISBN: 978-1-4244-5031-2

## Description

### Field of the Invention

The present invention relates to a power amplifier employed in mobile telecommunications systems, particularly an RF power amplifier commonly known as a Doherty amplifier.

### Background Art

In mobile telecommunication systems it is required that a power amplifier in a mobile base station should operate with high efficiency and high linearity simultaneously. "Efficiency" is generally regarded as the ratio of RF transmission output power to DC input power. "Linearity" has various measures, but a common measure is ACLR - adjacent channel power leakage ratio. There is a trade off between efficiency and linearity, with improvement in one coming at the expense of another. Many wireless communications systems, such as GSM/EDGE, CDMA2000, or WCDMA/LTE, require that the power amplifier should deliver a wide range of output powers. As a result, being designed for the highest power level with maximum available efficiency, power amplifiers in base stations tend to operate less efficiently at lower power levels consuming a lot of extra dc power. Therefore, there is a challenge to design a base station power amplifier having high efficiency and high linearity not only at maximum output power but also at lower power levels typically ranging from -6 dB and less. It is possible to employ linearization schemes to improve linearity, but these introduce extra complexity.

US Patent No. 2,210,028 to Doherty describes the principle of operation of the Doherty amplifier. A Doherty amplifier includes a main or carrier amplifier, usually biased into class B or AB, with a peaking amplifier coupled in parallel and biased into class C, so as to switch on at modulation peaks. This provides a more efficient use of amplifier capability, since the carrier amplifier may be set to provide maximum power efficiency at saturation, backed off by -6 dB from the peak output. When the peaking amplifier switches in at the -6 dB point to increase power to the antenna load, an impedance inverter at the output of the carrier amplifier senses an increase in load impedance and provides an apparent lower impedance at the carrier amplifier output, thereby increasing power output of the carrier amplifier.

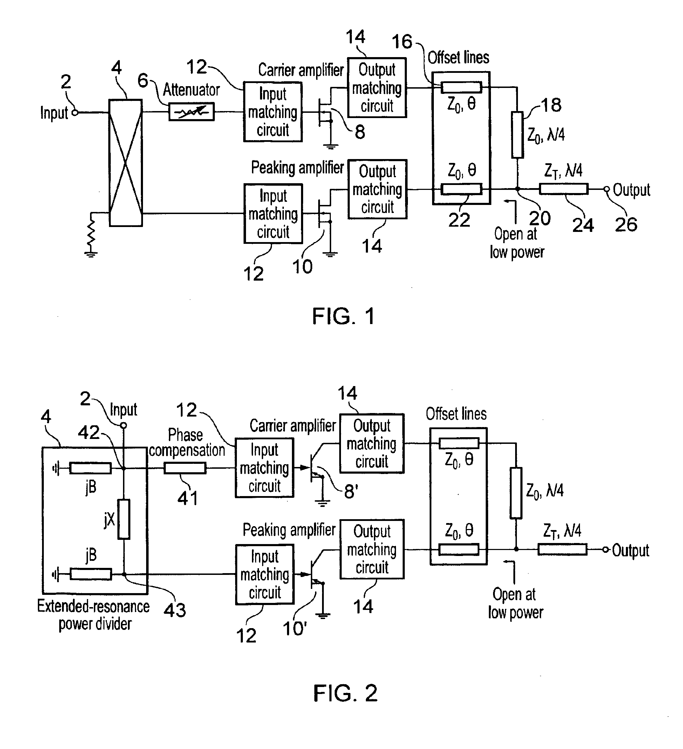

There has been a great deal of development in improving the operation and efficiency of the Doherty Amplifier. One means of improving the efficiency over the whole backoff power range is based on using uneven input power dividers, so that the input signal applied to the carrier amplifier is of a different magnitude to that applied to the peaking amplifier. An uneven input drive is desirable to provide higher drive to the carrier amplifier at a low power region when peaking amplifier is turned off and higher drive to the peaking amplifier when both carrier and peaking amplifiers are turned on, thus increasing efficiency around both peak efficiency points. In J. Kim et al., "Optimum Operation of Asymmetrical-Cells-Based Linear Doherty Power Amplifiers - Uneven Power Drive and Power Matching," IEEE Trans. Microwave Theory Techn., vol. MTT-53, pp. 1802-1809, May 2005, a Doherty amplifier, shown schematically in Figure 1, is described where higher input power is delivered to the peaking amplifier rather than the carrier amplifier for optimised linear power operation, especially for appropriate load modulation. In Figure 1, a Doherty amplifier has an input 2 coupled by an uneven power divider 4, which is adjusted by a variable attenuator 6. Divider 4 is coupled to a carrier amplifier 8 and to a peaking amplifier 10, which comprise FETs, and which have input and output impedance matching circuits 12, 14. The output of carrier amplifier 8 is coupled via a phase offset line length 16 and a quarter wavelength impedance inverting line 18 to an output node 20. The output of peaking amplifier 10 is coupled via a phase offset line length 22 to output node 20. Output node 20 is coupled, via an impedance transforming quarter wavelength line 24, to the output 26 of the Doherty amplifier. Problems with this proposal include resistive losses of the attenuator and that a preliminary optimization of power division ratio is fixed in a final circuit.

M. Nick and A. Mortazawi, "Adaptive Input-Power Distribution in Doherty Power Amplifiers for Linearity and Efficiency Enhancement," IEEE Trans. Microwave Theory Techn., vol. MTT-58, pp. 2764-2771, Nov. 2010 discloses a Doherty amplifier as shown in Figure 2, where similar parts to those of Figure 1 are denoted by the same reference numerals. In Figure 2, the input power divider 4 comprises a so-called extended resonance divider, and a phase compensation line 41, which is coupled to the input of a carrier amplifier 8', which comprises a bipolar transistor. Divider 4 is also coupled to the input of a peaking amplifier 10'. Divider 4 comprises a susceptance jB connected between earth and a divider output 42 coupled to amplifier 8'. A further susceptance jB is connected between earth and a divider output 43, which is coupled to peaking amplifier 10'. A reactance jX is connected between outputs 42, 43. The power division ratio between amplifiers 8', 10' is dependent on the amount of input power, being dependent on the ratio of (varying) input admittances of amplifiers 8', 10'. The behaviour mainly depends on the reflected power from the peaking amplifier. The input impedance of the peaking amplifier exhibits non-linear behaviour and is a strong function of the bias voltage. The major problems therefore with this approach are the dependence of the input power divider division ratio on the input impedance of the transistor devices which is different for different devices, and further a lack of adjustment possibilities.

Patent document US 2010/0052779 shows another example of a Doherty amplifier with a controlled impedance at its input.

### Summary of the Invention

The present invention provides in one aspect an RF power amplifier including a carrier amplifier, and at least one peaking amplifier,
a power dividing means coupled between an input of the power amplifier and inputs of said carrier amplifier and said one peaking amplifier, the output of said carrier amplifier being coupled through an impedance inversion means to a power amplifier output, and the output of said one peaking amplifier being coupled to said carrier amplifier output, and wherein said one peaking amplifier is configured to switch on with increase in input power,
said power dividing means including control means for providing a control signal which is dependent on the magnitude of the input signal applied to the input of the power amplifier,
and the power dividing means including a variable impedance means whose value is dependent on the value of the control signal, whereby as the magnitude of said input signal increases, the proportion of the input signal applied to said one peaking amplifier increases, and the proportion of the input signal applied to the carrier amplifier decreases.

In an embodiment, the use of said control means permits the possibility of the implementation of a wide range of power division ratios in the power dividing means, thereby greatly assisting in the set up of the power amplifier, and obtaining a set up wherein factors of efficiency and linearity are optimised, independent of the specific means used for achieving power division. Said control means may be analog or digital in form as will be described.

The variable impedance means might for example comprise a variable resistance, a transistor circuit, a voltage controlled tunable inductor or a voltage controlled capacitor (varactor). However the use of resistances may involve the undesirable consumption of input power, and the use of transistors for providing variable impedance paths may introduce unnecessary complexity and power consumption. Therefore passive tunable inductors and varactors are preferred, in particular varactors which are very versatile and permit use in a variety of situations.

Said power dividing means may in principle comprise any of the types that are used a microwave frequencies suitable for mobile telecommunications, which include directional couplers, branch-line couplers (90° hybrid coupler or quadrature coupler) ,Lange couplers, Wilkinson power dividers, hybrid ring couplers, and discrete element types, such as transformers and resistive tee (although having the disadvantage of power consumption). It would be possible to modify the construction of any of these types of power dividers in order to provide a variable coupling between input port and output (coupled) port. For example a directional coupler, which has a conductive path between ports 1 and 2, and a conductive path between ports 3 and 4, with a coupling K between the two paths, might be modified by providing a variable coupling between the two conductive paths, by appropriate connection of said variable impedance means. Or for example a Lange coupler, which includes interdigitated fingers, may have coupling factors modified by appropriate loading of the interdigitated fingers with said variable impedance means.

However as a practical matter, since power dividers are usually predesigned and/or supplied as fixed items, it is preferred, in accordance with an embodiment of the invention, that a variable impedance means should be coupled to an outlet port of a power divider, preferably between the outlet port and a reference potential, so that depending on the value of the impedance, power is selectively passed to a peaking amplifier coupled to the outlet port, or alternatively is reflected back into the outlet port, reappearing at another port of the power divider, to which is coupled the carrier amplifier. Such an arrangement requires careful consideration of phase shifts occurring within the power divider and upon reflection. It has been found that four port couplers providing a 90° phase shift between ports 2 and 3 (transmitted and coupled ports) will provide appropriate phase shifts to permit the desired flow of power to the carrier and peaking amplifiers. Couplers such as Wilkinson power dividers and hybrid ring couplers, which may provide 180° phase shift between output ports, and which may be 3 port devices, will not provide appropriate phase shifts.

Further in accordance with a preferred embodiment of the invention, in order to avoid power losses and provide full input power transfer during all modes of operation of the power divider means, the power dividing means comprises first and second power dividers or couplers, with one or more connecting paths between them to which is connected said variable impedance means, so as to alter the amount of power flowing between the two couplers. Preferably a first connecting path is provided between port 3 of a first coupler and port 2 of a second coupler, and a second connecting path is provided between port 2 of the first coupler and port 3 of a second coupler. Such an arrangement has the additional advantage of ensuring a high degree of isolation between the amplifier inputs and the mechanism for achieving a variable power division ratio, in contrast to the prior art.

It is preferred to use power dividers with low insertion loss and good isolation between the ports. To this end directional couplers and Lange couplers may be employed. This ensures that the input impedances of the carrier and peaking amplifiers do not affect the power division ratio. Nevertheless branch line couplers (90° hybrid couplers) may be preferred since they can provide a 3dB (50/50) power division between transmitted port 2 and coupled port 3, which is more difficult to achieve with a directional coupler. Couplers may be employed formed either of transmission line lengths, or where appropriate, lumped circuit components.

In an embodiment, in the architecture of a Doherty amplifier, the input power is divided between the carrier and peaking amplifiers using an adaptive input divider which includes varactor diodes to vary power division in accordance to the signal envelope by varying control voltage which ultimately changes the varactor junction capacitances. This is required to adaptively adjust drive levels during transition from high to low power mode to generate enough output in high-power mode and to prevent the power waste at low drive levels when the peaking amplifier is turned off. Varactors can be replaced by discrete capacitors when optimum power division at the input is established.

Embodiments of the invention provide a highly efficient operation of the base station power amplifier at maximum and backoff output power levels with better linearity performance.

### Brief Description of the Drawings

Preferred embodiments of the invention will now be described, by way of example only, with reference to the accompanying drawings, wherein:
Figure 1 is a circuit diagram of a Doherty amplifier incorporating a power divider, according to Kim referenced above;
Figure 2 is a circuit diagram of a Doherty amplifier incorporating a power divider, according to Nick referenced above;
Figure 3 is a circuit diagram of a Doherty amplifier incorporating a power divider, according to a first embodiment of the invention;
Figure 4 is a circuit schematic of a known branch line coupler, indicating relative phase shifts at ports;
Figures 5(a) and 5(b) are schematic diagrams of two possible limiting states of operation of the amplifier of Figure 3, included for explanation; and
Figures 6 to 8 are circuit diagrams of a Doherty amplifier incorporating a power divider, according to second, third and fourth embodiments of the invention, with different means of creating a signal envelope; and
Figure 9 is a circuit diagram of a Doherty amplifier incorporating a power divider, according to a fifth embodiment of the invention, being a multi-stage Doherty amplifier.

### Description of the Embodiments

In the embodiments to be described, the input divider, which comprises two directional couplers and two varactor diodes biased with the same voltage, is based on reflection-type principle where one part of the input signal is reflected from the capacitors and flows to the isolation port of the first coupler and the other part flows through to the output port of the second coupler. For zero capacitances there is no reflection and power flows only to the peaking amplifier, but for infinite capacitances providing zero reactances all power is reflected and flows to the carrier amplifier. As a result, by optimizing the values of the capacitances by proper varactor biasing, an optimum input power division for higher efficiency and better linearity can be achieved. The control voltage to the varactors is supplied from the feedback path and digital signal processing unit.

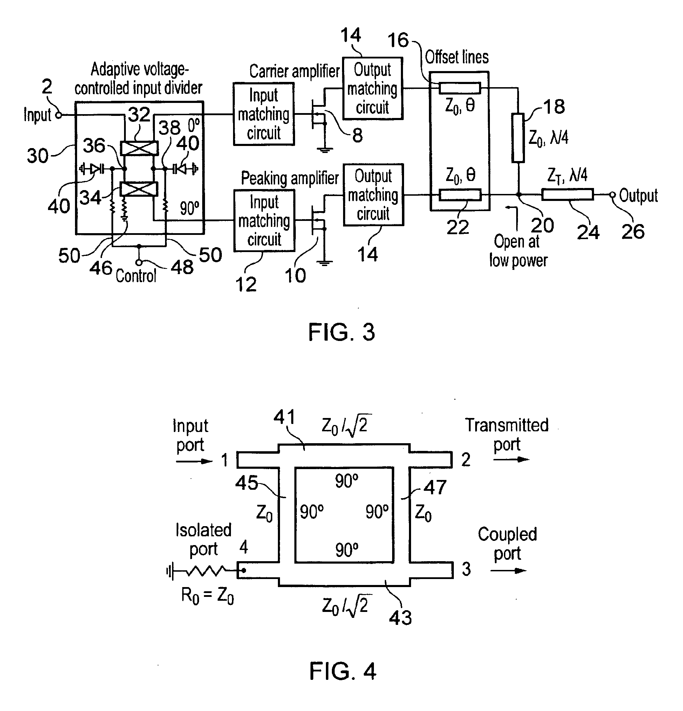

In the Figures, similar parts are denoted by the same reference numeral. Referring to Figure 3, a Doherty amplifier includes an uneven power divider 30, comprising first and second four port couplers 32, 34 coupled together by lines 36, 38, to each of which is connected a voltage controlled capacitor (varactor) 40, the other terminals of the varactors being coupled to earth.

A schematic view of a branch line coupler is shown in Figure 4, with Input port 1 connected by a conductive path (e.g. microstrip) 41, which comprises a quarter wavelength transmission line (with characteristic impedance Z₀/√2), to Transmitted port 2. Isolated port 4 is connected by a conductive path 43, a quarter wavelength transmission line (characteristic impedance Z₀/√2), to Coupled port 3. Port 1 is connected to port 4 by a quarter wavelength conductive path 45 (characteristic impedance Z₀), and transmitted port 2 is connected to coupled port 3 by a quarter wavelength conductive path 47 (characteristic impedance Z₀). The theory of operation of such couplers is well understood, and relative phase shifts of 90° occur between adjacent ports as shown. In particular there is a relative phase shift of 90° between Transmitted port 2 and Coupled port 3. In the usual configuration as shown of the coupler, there is zero output at port 4, and this is connected to ground via a terminating impedance. However in this embodiment, the designation of the ports is not significant, but arbitrary, since the coupler exhibits reciprocity and in the arrangement shown in Figure 3 input signals may flow into a coupler via various ports.

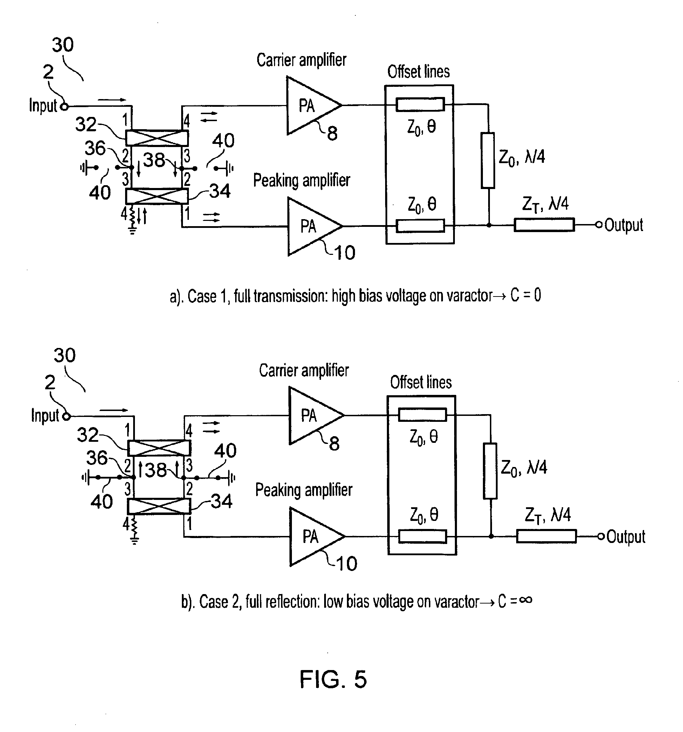

it may be seen from Figures 3, 4 and 5, that port 2 of coupler 32 is directly connected by line 36 to port 3 of coupler 34, and that port 3 of coupler 32 is directly connected by line 38 to port 2 of coupler 34. From Figures 3 and 5 it may be seen that the input of amplifier 8 is coupled to port 4 of coupler 32, and the input of amplifier 10 is coupled to port 1 of coupler 34. In addition isolating port 4 of coupler 34 is coupled to earth via a matching impedance 46.

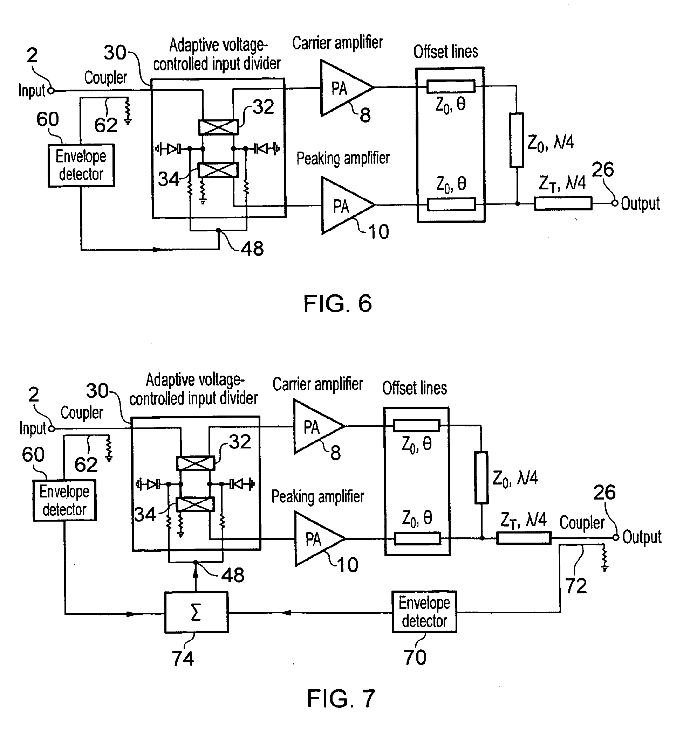

A control signal, representing the envelope of the input signal at 2, is applied to a control input 48, and conducted by lines 50 to the anodes of varactors 40. This signal represents the magnitude of the amplitude of the input signal, smoothed to take out the phase variations due to the base frequency of the input signal. A simple envelope detector may be formed by a diode and integrating capacitor (see: http://en.wikipedia.org/wiki/Envelope detector). Specific forms of envelope detection are described below with reference to Figures 6 to 8.

The manner of operation of divider 30 is explained with reference to Figure 5. A Doherty amplifier at low power input signals will function with only the carrier amplifier 8 operative. But for higher power inputs, 6dB below the maximum value, the peak amplifier becomes operative. These two states are illustrated in Figure 5, Figure 5(a) illustrating the limiting case of the high power state, and Figure 5(b) illustrating the limiting case for the low power state. In practice, the state of the amplifier will be part-way between these two limiting states.

In Figure 5(b), for very low power input signals, the magnitude of the envelope is very small, and hence the control signal will not change the capacitance of varactors 40, from a high value. In the limiting case, the capacitance tends to infinity, and the resultant impedance, 1/jωC, goes to zero. Hence the varactors may be represented by a short circuit to earth, as shown. In this case, the input power conducted through directional coupler 32 will be reflected back at the short circuit discontinuities, and will be wholly transmitted to the carrier amplifier 8. Thus, the input signal at port 1 of coupler 32 is transmitted to ports 2 and 3, and then totally reflected at varactors 40 (with 180° phase shift) back to respective ports 2 and 3. Input power to port 3 will be transmitted to port 4 and thence to carrier amplifier 8. Input power to port 2 will also be transmitted to port 4 and thence to carrier amplifier 8.. As the signal components flow through coupler 32, they will experience 90° phase shifts in the legs 41 - 47, but these shifts add constructively, and all the signal components are transmitted in-phase to amplifier 8.

In Figure 5(a), for high power input signals, the magnitude of the envelope is very large, and hence the control signal will change the capacitance of varactors 40, to a low value. In the limiting case, the capacitance tends to zero, and the resultant impedance, 1/jωC, goes to infinity. Hence the varactors 40 may be represented by an open circuit, as shown. In this case, the input power conducted through coupler 32 will be unaffected by these open circuits, and is conducted into coupler 34, whence into peaking amplifier 10. There are two components for the input signal into peaking amplifier 10, firstly ports 1 and 2 of coupler 32 and ports 3 and 1 of coupler 34. The second component flows through ports 1 and 3 of coupler 32 and ports 2 and 1 of coupler 34. As the signal components flow through couplers 32 and 34, they will experience 90° phase shifts in the legs 41 - 47, but these shifts add constructively, and these two components arrive in phase at the input to peaking amplifier 10. As regards the input signal to carrier amplifier 8, there is no net signal in this limiting case.

Referring to the second embodiment shown in Figure 6, a specific envelope detector 60 is shown, having a current sensing coupling 62 to input 2. As stated above, the envelope detector may comprise an arrangement of rectifying diode and integrating capacitor.

Referring to the third embodiment shown in Figure 7, a further arrangement of envelope detection is shown which gives a more accurate estimate of the envelope of the power signal. A further envelope detector 70 is provided, coupled at 72 to sense the signal at the output 26 of the Doherty amplifier. The signals from detectors 60, 70 are summed in a summation circuit 74, and are then applied to the control input 48.

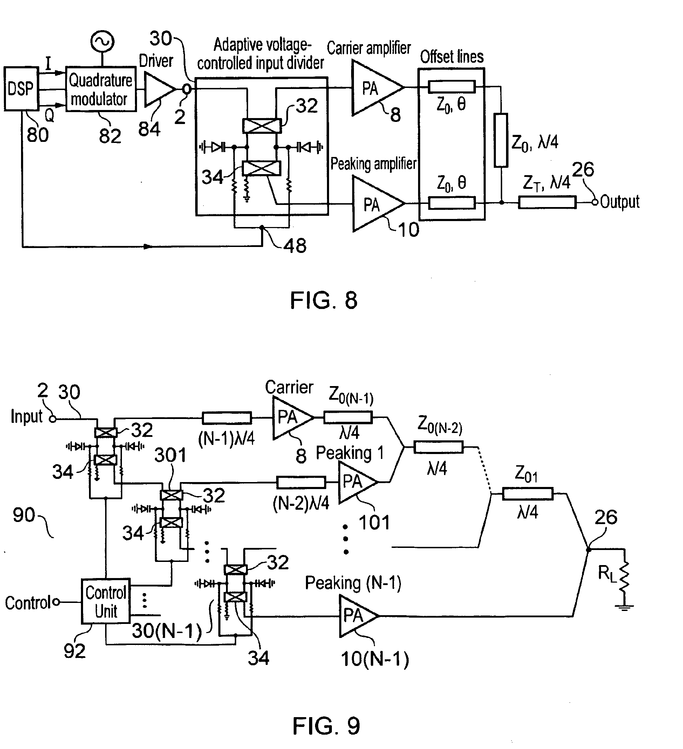

Referring to the third embodiment shown in Figure 8, a DSP digital signal processor 80 generates both input signals to the amplifier, and an envelope signal to the control input 48. The DSP 80 generates I, Q signals. These signals are combined in a Quadrature modulator 82 into a single input signal with two components I, Q which are 90 degrees out of phase. This input signal is connected via a driver amplifier 84 to the power input 2 of the Doherty amplifier.

Referring to the fourth embodiment shown in Figure 9, this is a schematic diagram of a multi stage (N) Doherty amplifier, employing two or more peaking amplifiers (as preferred, only two peaking amplifiers for practicality). The peaking amplifiers 101, ...10i....10(N-1) are arranged to switch on sequentially, as the power of the input signal increases. An array of power dividers 90 provide input signals to the amplifiers. A first path is connected to a carrier power amplifier 8, and (N-1) paths coupled to peaking amplifiers 101 to 10(N-1), having appropriate transmission lines of length λ/4 to (N-1)λ/4 in their input lines. A chain of (N-1) λ/4 lines of impedance Z_{0(N-1)} to Z₀₁ is coupled between the output of Carrier amplifier 8 and the output 26 of the Doherty amplifier, and the outputs of the peaking amplifiers are coupled to nodes between such impedances. It will be noted that this architecture is based on the classic two stage Doherty amplifier, which is exhibited by peaking amplifier 101, connected in parallel with Carrier amplifier 8 and its output inverting impedance Z₀(N-1). As the peaking amplifiers are turned on sequentially, the classic Doherty configuration is again exhibited with the next peaking amplifier due to switch on. In order to maintain phase balance, transmission lines are connected between the divider array and the peaking amplifiers, the lines having a length increasing from (N-1) λ /4 to λ/4.

The divider array comprises a first divider 30, as shown in Figure 3, coupled to carrier amplifier 8. The divider 30 is also coupled to peaking amplifier 101, but via a second divider 301 (similar to divider 30), the first directional coupler 32 of the divider 301 being connected in the input line to amplifier 101. The second directional coupler 34 of divider 301 is coupled to a third divider 302, with the coupler 32 of divider 302 being connected in the input line of peaking amplifier 102, and the second coupler 34 being coupled to the input of peaking amplifier 103, but via the first coupler 32 of a fourth divider 303, etc., etc. The final power divider 30(N-1) in the array has its second coupler 34 connected to the input line of peaking amplifier 10(N-1). A control unit 92 distributes appropriate envelope control signals to the individual power dividers.

The description and drawings merely illustrate the principles of the invention. It will thus be appreciated that those skilled in the art will be able to devise various arrangements that, although not explicitly described or shown herein, embody the principles of the invention and are included within its scope as defined by the appended claims. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A power amplifier including a carrier amplifier, and at least one peaking amplifier,
a power dividing means coupled between an input of the power amplifier and inputs of said carrier amplifier and said one peaking amplifier, the output of said carrier amplifier being coupled through an impedance inversion means to a power amplifier output, and the output of said one peaking amplifier being coupled to said carrier amplifier output, and wherein said one peaking amplifier is configured to switch on with increase in input power,
said power dividing means including control means for providing a control signal which is dependent on the magnitude of the input signal applied to the input of the power amplifier,
and the power dividing means including a variable impedance means whose value is dependent on the value of the control signal, whereby as the magnitude of said input signal increases, the proportion of the input signal applied to said one peaking amplifier increases, and the proportion of the input signal applied to the carrier amplifier decreases.

2. A power amplifier according to claim 1 wherein the variable impedance means comprises a voltage controlled tunable inductor or a voltage controlled capacitor (varactor).

3. A power amplifier according to claim 1 or 2, wherein the power divider means includes a coupler having input, transmitted and coupled ports, wherein a 90° phase shift exists between signals appearing at transmitted and coupled ports, for a signal applied to the input port.

4. A power amplifier according to claim 3, wherein the power divider means includes a directional coupler, or a Lange coupler, or a branch line coupler.

5. A power amplifier according to claim 3 or 4, wherein said variable impedance means is coupled to an outlet port of a said coupler, so that depending on the value of the impedance, power is selectively passed to a peaking amplifier coupled to the outlet port, or alternatively is reflected back into the outlet port, reappearing at another port of the coupler, to which is coupled the carrier amplifier.

6. A power amplifier according to claim 5, wherein said power dividing means comprises first and second couplers, with one or more connecting lines between them, to the or each of which is connected a respective variable impedance means, so as to alter the amount of power that may flow between the two couplers

7. A power amplifier according to claim 6, wherein a first coupler has a port 4 coupled to the carrier amplifier, a port 2 connected via a first connecting line to a port 3 of a second coupler, and a port 3 connected via a second connecting line to a port 2 of the second coupler, and a port 1 of the second coupler being coupled to said one peaking amplifier.

8. A power amplifier according to any preceding claim, wherein said control means includes a coupling device for sensing the power at the input of the power amplifier, and an envelope detector circuit coupled to said coupling device.

9. A power amplifier according to claim 8, including a further coupling device for sensing the power at the output of the power amplifier, a further envelope detector circuit coupled to said further coupling device, and summation means for summing the outputs of the envelope detector circuits.

10. A power amplifier according to any preceding claim, including a digital signal processor circuit, which includes said control means for generating said control signal.

11. A power amplifier according to claim 10, wherein said digital signal processor circuit includes means for generating I and Q signals, and including a quadrature modulator for combining the I and Q signals, and a driver amplifier coupled to said modulator, coupled to the input of the power amplifier.

12. A power amplifier according to any preceding claim, including at least first and second peaking amplifiers, and including a second power dividing means coupled between an input of the first peaking amplifier and inputs of said carrier amplifier and the second peaking amplifier.

## Patentansprüche

1. Leistungsverstärker, umfassend einen Trägerfrequenzverstärker und mindestens einen Spitzenverstärker,
ein Leistungsteilungsmittel, welches zwischen einem Eingang des Leistungsverstärkers und Eingängen des besagten Trägerfrequenzverstärkers und des besagten einen Spitzenverstärkers gekoppelt ist, wobei der Ausgang des besagten Trägerfrequenzverstärkers über ein Impedanzinversionsmittel an einen Leistungsverstärkerausgang gekoppelt ist und der Ausgang des besagten einen Spitzenverstärkers an den besagten Trägerfrequenzverstärkerausgang gekoppelt ist, und wobei der besagte eine Spitzenverstärker für das Einschalten mit einer ansteigenden Eingangsleistung konfiguriert ist,
wobei das besagte Leistungsteilungsmittel Steuerungsmittel zur Bereitstellung eines von der Größe des auf den Eingang des Leistungsverstärkers angewendeten Eingangssignals abhängigen Steuersignals umfasst,
und wobei das besagte Leistungsteilungsmittel ein Mittel mit variabler Impedanz umfasst, dessen Wert vom Wert des Steuersignals abhängt, wobei sich der Anteil des auf den Trägerfrequenzverstärker angewendeten Eingangssignals mit der Anhebung des Eingangssignals verringert.

2. Leistungsverstärker nach Anspruch 1, wobei das Mittel mit variabler Impedanz einen spannungsgesteuerten abstimmbaren Induktor oder einen spannungsgesteuerten Kondensator (Varaktor) umfasst.

3. Leistungsverstärker nach Anspruch 1 oder 2, wobei das Leistungsteilungsmittel einen Koppler mit einem Eingang sowie übertragenen und gekoppelten Ports umfasst, wobei zwischen den an übertragenen und gekoppelten Ports erscheinenden Signalen für ein auf den Eingangsport angewendetes Signal eine Phasenverschiebung um 90° besteht.

4. Leistungsverstärker nach Anspruch 3; wobei das Leistungsteilungsmittel einen Richtkoppler, oder einen Lange-Koppler, oder einen Abzweigleitungskoppler umfasst.

5. Leistungsverstärker nach Anspruch 3 oder 4, wobei das besagte Mittel mit variabler Impedanz an einen Ausgangsport des besagten Kopplers gekoppelt ist, so dass die Leistung in Abhängigkeit vom Wert der Impedanz selektiv an einen an den Ausgangsport gekoppelten Spitzenverstärker weitergeleitet oder alternativ an den Ausgangsport zurückreflektiert wird und erneut an einem anderen Port des Kopplers, an welchen der Trägerfrequenzverstärker angeschlossen ist, erscheint.

6. Leistungsverstärker nach Anspruch 5, wobei das besagte Leistungsteilungsmittel einen ersten und einen zweiten Koppler mit einer oder mehreren Verbindungsleitungen zwischen diesen umfasst, an welche ein jeweiliges Mittel mit variabler Impedanz angeschlossen ist, um die Leistungsmenge, welche zwischen den beiden Kopplern fließen kann, zu verändern.

7. Leistungsverstärker nach Anspruch 6, wobei ein erster Koppler einen Port 4, welcher an den Trägerfrequenzverstärker gekoppelt ist, einen Port 2, welcher über eine erste Verbindungsleitung an einen Port 3 des zweiten Kopplers angeschlossen ist, und einen Port 3, welcher über eine zweite Verbindungsleitung an einen Port 2 des zweiten Kopplers angeschlossen ist, aufweist, und wobei ein Port 1 des zweiten Kopplers an den besagten einen Spitzenverstärker gekoppelt ist.

8. Leistungsverstärker nach einem beliebigen der vorstehenden Ansprüche, wobei das besagte Steuerungsmittel eine Kopplungsvorrichtung zum Erfassen der Leistung am Eingang des Leistungsverstärkers und eine an die besagte Kopplungsvorrichtung gekoppelte Hüllkurvenerfassungsschaltung umfasst.

9. Leistungsverstärker nach Anspruch 8, umfassend eine weitere Kopplungsvorrichtung zum Erfassen der Leistung am Ausgang des Leistungsverstärkers, eine weitere an die besagte weitere Kopplungsvorrichtung gekoppelte Hüllkurvenerfassungsschaltung und Summationsmittel zum Summieren der Ausgangssignale der Hüllkurvenerfassungsschaltungen.

10. Leistungsverstärker nach einem beliebigen der vorstehenden Ansprüche, umfassend eine digitale Signalprozessorschaltung, welche das besagte Steuerungsmittel umfasst, um das besagte Steuersignal zu erzeugen.

11. Leistungsverstärker nach Anspruch 10, wobei die besagte digitale Signalprozessorschaltung Mittel zum Erzeugen von I- und Q-Signalen umfasst, und umfassend einen Quadraturmodulator zum Kombinieren der I- und Q-Signale und einen an den besagten Modulator, welcher an den Eingang des Leistungsverstärkers gekoppelt ist, gekoppelten Treiberverstärker.

12. Leistungsverstärker nach einem beliebigen der vorstehenden Ansprüche, umfassend zumindest einen ersten und einen zweiten Spitzenverstärker, und umfassend ein zweites Leistungsteilungsmittel, welches zwischen einem Eingang des ersten Spitzenverstärkers und Ausgängen des besagten Trägerfrequenzverstärkers und dem zweiten Spitzenverstärker gekoppelt ist.

## Revendications

1. Amplificateur de puissance comprenant un amplificateur de porteuse, et au moins un amplificateur de crête,
des moyens de division de puissance couplés entre une entrée de l'amplificateur de puissance et des entrées dudit amplificateur de porteuse et dudit amplificateur de crête, la sortie dudit amplificateur de porteuse étant couplée par l'intermédiaire de moyens d'inversion d'impédance à une sortie de l'amplificateur de puissance, et la sortie dudit amplificateur de crête étant couplée à ladite sortie de l'amplificateur de porteuse, et dans lequel ledit amplificateur de crête est configuré pour s'activer avec l'augmentation de la puissance d'entrée,
lesdits moyens de division de puissance comprenant des moyens de commande pour fournir un signal de commande qui dépend de l'amplitude du signal d'entrée appliqué à l'entrée de l'amplificateur de puissance,
et les moyens de division de puissance comprenant des moyens à impédance variable dont la valeur dépend de la valeur du signal de commande, de telle sorte qu'au fur et à mesure que l'amplitude dudit signal d'entrée augmente, la proportion du signal d'entrée appliqué audit amplificateur de crête augmente, et la proportion du signal d'entrée appliqué à l'amplificateur de porteuse diminue.

2. Amplificateur de puissance selon la revendication 1 dans lequel les moyens d'impédance variable comprennent un inducteur accordable commandé en tension ou un condensateur commandé en tension (varactor).

3. Amplificateur de puissance selon la revendication 1 ou 2, dans lequel les moyens de division de puissance comprennent un coupleur ayant des ports d'entrée, transmis et couplés, dans lequel un déphasage de 90° existe entre des signaux apparaissant à des ports transmis et couplés, pour un signal appliqué au port d'entrée.

4. Amplificateur de puissance selon la revendication 3, dans lequel les moyens de division de puissance comprennent un coupleur directionnel, ou un coupleur de Lange, ou un coupleur à interaction localisée.

5. Amplificateur de puissance selon la revendication 3 ou 4, dans lequel lesdits moyens d'impédance variable sont couplés à un port de sortie d'un desdits coupleurs, de sorte qu'en fonction de la valeur de l'impédance, la puissance est transférée de manière sélective vers un amplificateur de crête couplé au port de sortie, ou en variante est renvoyé dans le port de sortie, réapparaissant à un autre port du coupleur, auquel l'amplificateur de porteuse est couplé.

6. Amplificateur de puissance selon la revendication 5, dans lequel lesdits moyens de division de puissance comprennent des premier et deuxième coupleurs, avec une ou plusieurs lignes de connexion entre eux, chacun étant connecté à un moyen d'impédance variable respectif, de sorte à modifier la quantité de puissance qui peut circuler entre les deux coupleurs

7. Amplificateur de puissance selon la revendication 6, dans lequel un premier coupleur présente un port 4 couplé à l'amplificateur de porteuse, un port 2 connecté par l'intermédiaire d'une première ligne de connexion à un port 3 d'un deuxième coupleur, et un port 3 connecté par l'intermédiaire d'une deuxième ligne de connexion à un port 2 du deuxième coupleur, et un port 1 du deuxième coupleur étant couplé audit amplificateur de crête.

8. Amplificateur de puissance selon l'une quelconque des revendications précédentes, dans lequel lesdits moyens de commande comprennent un dispositif de couplage pour détecter la puissance à l'entrée de l'amplificateur de puissance, et un circuit de détection d'enveloppe couplé audit dispositif de couplage.

9. Amplificateur de puissance selon la revendication 8, comprenant un autre dispositif de couplage pour détecter la puissance à la sortie de l'amplificateur de puissance, un autre circuit de détection d'enveloppe couplé audit autre dispositif de couplage, et des moyens d'addition pour additionner les sorties des circuits de détection d'enveloppe.

10. Amplificateur de puissance selon l'une quelconque des revendications précédentes, comprenant un circuit de traitement de signaux numériques, qui comprend lesdits moyens de commande pour générer ledit signal de commande.

11. Amplificateur de puissance selon la revendication 10, dans lequel ledit circuit de traitement de signaux numériques comprend des moyens pour générer des signaux I est Q, et comprenant un modulateur en quadrature pour combiner les signaux I et Q, et un amplificateur de commande couplé audit modulateur, couplé à l'entrée de l'amplificateur de puissance.

12. Amplificateur de puissance selon l'une quelconque des revendications précédentes, comprenant au moins un premier et un deuxième amplificateurs de crête, et comprenant des deuxièmes moyens de division de puissance couplés entre une entrée du premier amplificateur de crête et des entrées dudit amplificateur de porteuse et du deuxième amplificateur de crête.
